# EUROPÄISCHE PATENTANMELDUNG

(11) **EP 4 629 126 A1**
(43) Veröffentlichungstag der Anmeldung: **08.10.2025**
(21) Anmeldenummer: 24168399.4
(22) Anmeldetag: 04.04.2024
(51) Int. Cl.: G06F 30/20, G06F 11/34, G06F 11/26

(54) **COMPUTERIMPLEMENTIERTES VERFAHREN ZUR CO-SIMULATION MIT EINEM HIL-SIMULATOR UND EINEM SIL-SIMULATOR**

(71) Anmelder: dSPACE GmbH, 33102 Paderborn (DE)
(72) Erfinder: Yunis, Rafael, 10000 Zagreb (HR); Isenberg, Tobias, 33102 Paderborn (DE)

(57) **Zusammenfassung**

Die Erfindung betrifft ein Computerimplementiertes Verfahren zur Co-Simulation mit einem in Echtzeit laufenden HIL-Simulator und einem in einer Simulationszeit laufenden SIL-Simulator, mit folgenden Verfahrensschritten:
Vorgeben eines periodischen Taktes mit in einer konstanten Taktdauer aufeinanderfolgenden Taktzeitpunkten,
a) Starten eines SIL-Simulationsschrittes,
b) Erzeugen einer Nachricht und Senden der Nachricht von dem SIL-Simulator an den HII,-Simulator, wenn der SIL-Simulationsschritt beendet ist,
c) Empfangen der Nachricht in einer Warteschlange des HII,-Simulators,
d) Auslesen jeweils einer Nachricht zu einem Taktzeitpunkt aus der Warteschlange von dem HIL-Simulator und Löschen dieser Nachricht in der Warteschlange derart, dass eine zuerst von der Warteschlange empfangene Nachricht vor einer später empfangen Nachrichten ausgelesen und dann in der Warteschlange gelöscht wird,
e) Wiederholen der Schritte a) bis d) bis zu einem Ende der Co-Simulation, wobei

der erste SIL-Simulationsschritt zu einem ersten Taktzeitpunkt gestartet wird und hinsichtlich der darauf folgenden SIL-Simulationsschritte in einem Fall, in dem die Dauer des unmittelbar vorherige SIL-Simulationsschritts maximal die Taktdauer betragen hat, der unmittelbar darauf folgende SIL-Simulationsschritt zum jeweils nächst möglichen Taktzeitpunkt gestartet wird, und ansonsten der unmittelbar darauf folgende SIL-Simulationsschritt sofort nach Abschluss des vorherige SIL-Simulationsschritts gestartet wird.

Auf diese Weise werden die bei einer Co-Simulation mit einem HIL- und einem SIL-Simulator die mit Loose Coupling verbundenen Nachteile vermieden, indem das Auftreten von zeitlichen Inkonsistenzen reduziert oder gänzlich vermieden wird.

## Beschreibung

Die Erfindung betrifft ein computerimplementiertes Verfahren zur Co-Simulation mit einem in Echtzeit laufenden HIL-Simulator und einem in einer Simulationszeit laufenden SIL-Simulator.

Das Unternehmen dSPACE stellt unter dem Namen Scalexio ein System zur Durchführung von Echtzeit-Simulationen und zur Implementierung von Hardware-in-the-Loop (HIL) Testumgebungen bereit, das insbesondere für Entwicklung und Validierung von Steuergeräten und Systemen in der Automobilindustrie vorgesehen ist. In der modernen Produktentwicklung, insbesondere in Bereichen, die hohe Sicherheits- und Zuverlässigkeitsanforderungen aufweisen, ist die Simulation ein unverzichtbares Werkzeug. Echtzeit-Simulationen und Hardware-in-the-Loop-Tests bieten die Möglichkeit, das Verhalten von Steuergeräten und Systemen unter realistischen Bedingungen zu testen, ohne dass physische Prototypen oder reale Einsatzbedingungen erforderlich sind. Dies reduziert Entwicklungszeiten und -kosten und erhöht gleichzeitig die Produktqualität und Sicherheit.

Traditionelle Simulations- und Testumgebungen stoßen jedoch an ihre Grenzen, wenn es um komplexe Systeme und hochdynamische Anwendungen geht. Die Anforderungen an Flexibilität, Skalierbarkeit und Leistungsfähigkeit steigen kontinuierlich. Es besteht daher ein dringender Bedarf an fortschrittlicheren Lösungen, die in der Lage sind, die zunehmend komplexen und vernetzten Systeme effizient zu simulieren und zu testen. Diese Herausforderungen werden durch die Bereitstellung eines fortschrittlichen Echtzeit-Simulations- und HIL-Testsystems adressiert, bekannt als Scalexio. Scalexio ist ein modulares, skalierbares System, das von dSPACE entwickelt wurde, um den anspruchsvollen Anforderungen moderner Entwicklungs- und Testumgebungen gerecht zu werden. Es bietet eine flexible Plattform für die Simulation und den Test von Steuergeräten und Systemen über ein breites Spektrum von Anwendungen und Branchen hinweg. Die Kernfunktionen umfassen die Unterstützung für komplexe Modellierungen, Echtzeit-Simulationen, umfassende I/O-Konfigurationen und benutzerfreundliche Schnittstellen für die Systemkonfiguration und -überwachung. Durch seine modulare Architektur kann Scalexio leicht an spezifische Anforderungen angepasst und für verschiedene Simulationsszenarien skaliert werden, was es zu einem vielseitigen Werkzeug in der Entwicklungs- und Testlandschaft macht.

Darüber hinaus stellt das Unternehmen dSPACE die Plattform VEOS bereit, die eine umfassende Plattform für die virtuelle Validierung bietet, die speziell dafür entwickelt wurde, Software-in-the-Loop (SIL)-Simulationen zu unterstützen. Diese Funktionen ermöglichen es Entwicklern und Ingenieuren, die Entwicklung und das Testen von Steuergerätesoftware und komplexen Systemmodellen in einer vollständig virtuellen Umgebung durchzuführen. Im Kontext von SIL-Simulationen bietet VEOS mehrere Schlüsselfunktionen und Vorteile.

VEOS ermöglicht die Erstellung virtueller ECUs, um die Software von Steuergeräten unabhängig von physischer Hardware zu simulieren. Dies ist besonders nützlich in den frühen Phasen der Entwicklung, wenn die tatsächliche Hardware möglicherweise noch nicht verfügbar ist. Die Plattform unterstützt die Integration von Modellen, die in verschiedenen Modellierungssprachen und -werkzeugen erstellt wurden, wie MATLAB/Simulink, um eine umfassende Systemsimulation zu ermöglichen. Dies ermöglicht die nahtlose Simulation des Zusammenspiels zwischen Steuergerätesoftware und dem zu steuernden Systemmodell. VEOS bietet Schnittstellen zu Werkzeugen für die Automatisierung von Tests, die es ermöglichen, große Mengen von Testfällen effizient durchzuführen und zu verwalten. Dies hilft, die Softwarequalität zu verbessern und die Entwicklungsdauer zu verkürzen. Umfangreiche Diagnose- und Visualisierungswerkzeuge für VEOS erleichtern die Identifizierung und Analyse von Problemen in der simulierten Steuergerätesoftware und im Systemmodell.

VEOS ermöglicht auch die Definition und Ausführung von Szenarien, die reale Betriebsbedingungen nachbilden. Dies hilft Entwicklern zu verstehen, wie sich die Software unter verschiedenen Bedingungen verhalten wird. Durch die Unterstützung von Simulationen, die mehrere Fachbereiche umfassen (z.B. Mechanik, Elektrik, Hydraulik), bietet VEOS eine ganzheitliche Sicht auf das Systemverhalten und fördert eine interdisziplinäre Zusammenarbeit. Die modulare Architektur von VEOS macht es einfach, die Plattform an spezifische Projektanforderungen anzupassen und erlaubt es, mit der Komplexität der zu entwickelnden Systeme zu skalieren. VEOS unterstützt branchenübliche Standards und Schnittstellen, was die Integration in bestehende Entwicklungsprozesse erleichtert und die Wiederverwendung von Modellen und Testfällen ermöglicht. Durch diese Funktionen ermöglicht VEOS eine effektive und effiziente Durchführung von SIL-Simulationen, was es zu einem universellen Werkzeug in der modernen System- und Softwareentwicklung macht, insbesondere in der Automobilbranche.

Bei einer Co-Simulation werden HIL- und SIL-Systeme so integriert, dass sie gleichzeitig und synchron laufen können. Dies bedeutet, dass Teile des Systems in Echtzeit auf physischer Hardware (HIL) und andere Teile parallel in einer virtuellen Umgebung (SIL) simuliert werden. Diese Integration ermöglicht eine umfassende Systemprüfung, bei der sowohl die Interaktion zwischen der Software und der realen Hardware als auch das Zusammenspiel verschiedener Systemkomponenten bewertet werden kann.

Der übliche Ansatz für Co-Simulationen und das gängige Verständnis von Co-Simulationen im Stand der Technik besteht darin, dass eine Komponente oder ein Subsystem das Timing des gesamten Simulationssystems übernimmt, so dass diese üblicherweise als Simulations-Master bezeichnet wird. Die vorliegende Erfindung befasst sich nicht mit dieser Art von Co-Simulation (auch als Strong Coupling bezeichnet), sie konzentriert sich vielmehr auf ein Simulationssystem, das aus zwei Subsystemen besteht, die eigenständige Simulatoren sind (z. B. VEOS und SCALEXIO, wie oben angesprochen), und anstatt einen externen Simulations-Master einzubeziehen oder einen der Simulatoren als Timing-Controller zu fördern, erlaubt sie beiden Simulatoren, ihr Timing-Verhalten beizubehalten und einfach Daten auszutauschen, wann immer sie verfügbar sind. Dieser Co-Simulationsansatz wird auch als Loose Coupling bezeichnet.

Dieser Ansatz hat den Vorteil, dass er die Simulationsleistung erhöht, indem er die Leerlaufzeiten beider Simulatorkomponenten reduziert und das Risiko einer Zeitüberschreitung (Task Overrun) in im Echtzeitsimulator (HIL) verringert. Dies hat jedoch den Nachteil, dass das Gesamtsystem nicht deterministisch ist und zeitliche Inkonsistenzen in der Kommunikation entstehen können. Diese Inkonsistenzen können z. B. in einer Drift zwischen den Simulatortakten, einem Verlust von Nachrichten, einer Verzögerung beim Empfang von Nachrichten oder einem Jitter im Bus-Timing-Abstand bestehen, um nur einige Beispiele zu nennen.

Wegen dieser Nachteile wird dieser Loose Coupling-Ansatz für die Co-Simulation bei modernen Produkten und Technologien nicht oft in Betracht gezogen, sondern es werden stattdessen häufig Strong Coupling-Ansätze bevorzugt. Strong Coupling kann jedoch für viele Simulationssysteme ungeeignet sein, insbesondere für reale Beispiele, die rechenintensiv sind.

Loose Coupling beinhaltet in der Regel eine Art von Pufferung. Die Kombination aus Loose Coupling und Pufferung führt bei einem SIL-Simulationsschritt, der länger dauert als bei dem HIL-System in Echtzeit, im SIL-System nur zu einer kleinen Verzögerung bei der Nachrichtenkommunikation und nicht zum Verlust der Echtzeitfähigkeit des HIL-Simulators. Dies ist im Hinblick auf Loose-Coupling-Ansätze bekannt. Im Falle des Austauschs von Bussimulationsdaten ist es außerdem üblich, nur Busnachrichten auszutauschen, wenn diese verfügbar sind.

Bei einem Loose-Coupling-Ansatz können jedoch Probleme bei der Kopplung des HIL-Simulators mit dem SIL-Simulator auftreten. Wie bereits beschrieben, ist es möglich, dass der SIL-Simulator vorübergehend nicht im Takt mit der HIL-Simulation läuft, weil ein Teil der Simulationsschritte im SIL-System länger dauern als die durch den Takt der Co-Simulation festgelegte Taktdauer, und weitere folgende Schritte danach in schneller Folge ausgeführt werden, um diese Verzögerung auszugleichen. Diese Situation kann zu einigen unbeabsichtigten Konsequenzen im Bus-Timing-Verhalten führen. Insbesondere können größere Verzögerungen auf dem SIL-Simulator zu erheblichen Warteschlangen und, wenn diese Warteschlangen zu groß werden, zu Datenverlusten führen.

Aus der DE 10 2017 214 125 A1 ist ein Verfahren zum Synchronisieren einer Simulation mit einem Echtzeitsystem bekannt, das die folgenden Verfahrensschritte aufweist: eine Nachricht des Echtzeitsystems wird abgewartet, ein Empfangszeitpunkt der Nachricht wird gemessen, mindestens eine weitere Nachricht des Echtzeitsystems wird abgewartet, der Empfangszeitpunkt der weiteren Nachricht wird gemessen, eine Zeitdifferenz zwischen den Empfangszeitpunkten wird gebildet, eine Abweichung der Zeitdifferenz zu einer vorgegebenen Makroschrittweite der Simulation wird ermittelt und anhand der Abweichung wird ein Startzeitpunkt der Simulation bestimmt.

Die WO 2019/219796 A1 beschreibt ein Verfahren zur ereignisbasierten Simulation eines Systems, wobei die Simulation auf einem Rechnersystem umfassend eine erste Recheneinheit und wenigstens eine zweite Recheneinheit ausgeführt wird, wobei die erste Recheneinheit eine Simulationszeit hat, wobei die zweite Recheneinheit eine Betriebssystemschicht und eine Applikationsschicht aufweist, wobei die zweite Recheneinheit in der Betriebssystemschicht eine Systemzeit aufweist, wobei wenigstens die zweite Recheneinheit eine Simulator-Applikation ausführt, wobei auf der Simulator-Applikation wenigstens ein Simulationsobjekt ausgeführt wird, und wobei die erste Recheneinheit eine Ereigniswarteschlange verwaltet, wobei in der Ereigniswarteschlange wenigstens ein Ereignis pro Simulationsschritt aufgelistet ist, und dem Ereignis ein durch das Simulationsobjekt auszuführender Prozess und ein zur Ausführung des Prozesses vorgesehener Simulationszeitpunkt zugeordnet sind, wobei die zweite Recheneinheit einen virtuellen Taktgeber aufweist, wobei das Verfahren für jeden Simulationsschritt die folgenden Schritte aufweist: Übermitteln, durch die erste Recheneinheit, eines Startsignals an den virtuellen Taktgeber zum Ausführen eines nächsten Simulationsschritts in der zweiten Recheneinheit, und basierend auf einer Zeitdifferenz zwischen einem vergangenen Simulationsschritt und der Simulationszeit, Inkrementieren der Systemzeit der zweiten Recheneinheit, und Ausführen des anstehenden Prozesses zu dem Prozess zugeordneten Simulationszeitpunkt.

Es ist die Aufgabe der Erfindung, bei einer Co-Simulation mit einem HIL-Simulator und einem SIL-Simulator mit Loose Coupling verbundene Nachteile zu vermeiden, indem das Auftreten von zeitlichen Inkonsistenzen reduziert oder gänzlich vermieden wird.

Diese Aufgabe wird durch den Gegenstand des Patentanspruchs 1 gelöst. Bevorzugte Weiterbildungen finden sich in den Unteransprüchen.

Erfindungsgemäß wird somit ein computerimplementiertes Verfahren zur Co-Simulation mit einem in Echtzeit laufenden HIL-Simulator und einem in einer Simulationszeit laufenden SIL-Simulator bereitgestellt, das die folgenden Verfahrensschritte aufweist:
Vorgeben eines periodischen Taktes mit in einer konstanten Taktdauer aufeinanderfolgenden Taktzeitpunkten,
   a) Starten eines SIL-Simulationsschrittes,
   b) Erzeugen einer Nachricht und Senden der Nachricht von dem SIL-Simulator an den HIL-Simulator, wenn der SIL-Simulationsschritt beendet ist,
   c) Empfangen der Nachricht in einer Warteschlange des HII,-Simulators,
   d) Auslesen jeweils einer Nachricht zu einem Taktzeitpunkt aus der Warteschlange von dem HIL-Simulator und Löschen dieser Nachricht in der Warteschlange derart, dass eine zuerst von der Warteschlange empfangene Nachricht vor einer später empfangen Nachrichten ausgelesen und dann in der Warteschlange gelöscht wird,
   e) Wiederholen der Schritte a) bis d) bis zu einem Ende der Co-Simulation, wobei
der erste SIL-Simulationsschritt zu einem ersten Taktzeitpunkt gestartet wird und hinsichtlich der darauf folgenden SIL-Simulationsschritte in einem Fall, in dem die Dauer des unmittelbar vorherige SIL-Simulationsschritts maximal die Taktdauer betragen hat, der unmittelbar darauf folgende SIL-Simulationsschritt zum jeweils nächst möglichen Taktzeitpunkt gestartet wird, und ansonsten der unmittelbar darauf folgende SIL-Simulationsschritt sofort nach Abschluss des vorherige SIL-Simulationsschritts gestartet wird.

Es ist somit ein wesentlicher Punkt der Erfindung, dass im Rahmen der Co-Simulation, die die parallele Nutzung eines Hardware-in-the-Loop (HIL) Simulators, der in Echtzeit arbeitet, und eines Software-in-the-Loop (SIL) Simulators beinhaltet, der in einer von der realen Zeit unabhängigen Simulationszeit läuft, nach dem Abschluss eines jeden SIL-Simulationsschritts eine Nachricht vom SIL-Simulator an den HIL-Simulator gesendet wird, wobei diese Nachricht in einer Warteschlange des HIL-Simulators aufgenommen wird, um dann zu einem festgelegten Taktzeitpunkt gelesen und anschließend aus der Warteschlange entfernt zu werden. Die Reihenfolge der Verarbeitung ist dabei so ausgestaltet, dass früher empfangene Nachrichten vor später eingetroffenen bearbeitet und gelöscht werden (FIFO-Prinzip, first in first out). Es wird dabei ein periodischer Takt vorgegeben, der aus aufeinanderfolgenden Taktzeitpunkten mit einer konstanten Dauer besteht.

Die Verfahrensschritte werden wiederholt, bis die Co-Simulation endet, typischer nachdem eine vorab vorgegebene Anzahl von Schritten abgearbeitet oder wenn ein bestimmtes Ergebnis erzielt worden ist. Hinsichtlich des Starts von aufeinanderfolgenden SIL-Simulationsschritten wird unterschieden: Wenn die Dauer des vorherigen Schritts maximal der Taktdauer entsprach, wird der nächste Schritt zum nächstmöglichen Taktzeitpunkt begonnen. Dauerte der vorherige Schritt allerdings länger, startet der nächste Schritt unmittelbar nach Abschluss des vorherigen Schritts, um das Nacheilen des SIL-Simulators so gering wie möglich zu halten.

Dadurch, dass nach jedem einzelnen SIL-Schritt eine Nachricht versendet wird, die in der Warteschlange gespeichert wird, kann es zwar dazu kommen, dass der SIL-Simulator dem HIL-Simulator nacheilt, wenn ein SIL-Schritt entsprechend länger gedauert hat. Durch die Pufferung der Nachrichten in der Warteschlange kommen die Nachrichten jedoch zu definierten Zeitpunkten im HIL-Simulator an, so dass eine korrekte Zuordnung und damit eine fehlerfreie Nutzung der Nachrichten im HIL-Simulator ermöglicht wird.

Die vom SIL-Simulator erzeugten Nachrichten können unterschiedliche Inhalte haben. Gemäß einer bevorzugten Weiterbildung der Erfindung gilt jedoch, dass beim Erzeugen einer Nachricht jedes Mal ein wenigstens eine Eigenschaft der Co-Simulation charakterisierendes Simulations-Metadatum in die Nachricht aufgenommen wird. Dieses Simulations-Metadatum weist vorzugsweise den aktuellen Zustand der Warteschlange, die simulierte Zeit und/oder die reale Zeit auf, die lokal in dem SIL-Simulator bzw. in dem HIL-Simulator vorliegt. Da gemäß dieser bevorzugten Ausgestaltung der Erfindung jede Nachricht ein solches Simulations-Metadatum aufweist und jede dieser Nachrichten nach Abschluss eines SIL-Schritts verschickt werden, wird bei dieser Art von Nachrichten auch von Heartbeat-Nachrichten gesprochen.

Neben solchen Simulations-Metadaten können die Nachrichten auch andere Inhalte aufweisen. Insbesondere ist es gemäß einer bevorzugten Weiterbildung der Erfindung vorgesehen, dass Busdaten zwischen dem SIL-Simulator und dem HIL-Simulator ausgetauscht werden. Konkret gilt dabei vorzugsweise, dass genau in jede n-te Nachricht ein wenigstens eine Eigenschaft eines Busses des SIL-Simulators charakterisierendes Busdatum aufgenommen wird, wobei n konstant, ganzzahlig und größer als 1 ist. Bei dem Bus des SIL-Simulators, für den ein diesen charakterisierendes Busdatum in die Nachricht aufgenommen wird, handelt es sich vorzugsweise um einen virtuellen Bus. Auf diese Weise ist es z. B. möglich, dass nach jedem SIL-Schritt eine Heartbeat-Nachricht verschickt wird und diese Heartbeat-Nachricht nach jedem fünften Schritt um ein Busdatum ergänzt wird, so dass eine Bus-Nachricht entsteht. Durch die Pufferung in der Warteschlange, die in dem vorgegebenen Takt ausgelesen wird, kommt es dazu, dass der HIL-Simulator selbst bei einem Nacheilen des SIL-Simulators alle fünf Takte ein Busdatum erhält, dass dann im HIL-Simulator entsprechend zugeordnet und weiterverarbeitet werden kann.

Gemäß einer bevorzugten Weiterbildung der Erfindung gilt, dass in einem Fall, in dem die Warteschlange mehr als eine vorbestimmte Anzahl an Nachrichten enthält, Schritt d) dahingehend ergänzt wird, dass nach dem Auslesen und Löschen der Nachricht die nachfolgende Nachricht in der Warteschlange ohne Auslesen gelöscht wird, sofern es sich hierbei nicht um eine Nachricht handelt, in die ein Busdatum aufgenommen worden ist. In diesem Zusammenhang ist es vorzugsweise so, dass in einem Fall, in dem die Nachricht nicht ohne Auslesen gelöscht worden ist, da es sich um eine Nachricht gehandelt hat, in die ein Busdatum aufgenommen worden ist, im nachfolgenden Schritt d) nach dem Auslesen und Löschen der Nachricht, in die ein Busdatum aufgenommen worden ist, die nachfolgende Nachricht in der Warteschlange ohne Auslesen gelöscht wird. Diese Vorgehensweisen ermöglichen es, ein Nacheilen des SIL-Simulators hinter dem HIL-Simulator in Grenzen zu halten, allerdings zu dem Preis, dass zumindest für zwei aufeinanderfolgende Nachrichten mit einem Busdatum der vorgegebene Taktabstand um einen Takt verringert wird: Wurden die Nachrichten mit einem Busdatum vorher so gesendet, dass jede fünfte Nachricht ein Busdatum aufgewiesen hat, so ist es vorliegend einmalig bereits die vierte Nachricht, die wieder ein Busdatum aufweist.

Die physikalische Kopplung des SIL-Simulators an den HIL-Simulator zum Versand von Nachrichten kann unterschiedlicher Natur sein. Gemäß einer bevorzugten Weiterbildung der Erfindung erfolgt der Versand der Nachricht von dem SIL-Simulator an den HIL-Simulator jedoch über Ethernet, vorzugsweise über Standard-Ethernet.

Nachfolgend wir die Erfindung anhand eines bevorzugten Ausführungsbeispiels unter Bezugnahme auf die Zeichnungen weiter im Detail erläutert.

In den Zeichnungen zeigen
- Fig. 1: schematisch ein Beispiel für einen aus dem Stand der Technik bekannten Strong Coupling-Ansatz zwischen einem SIL-Simulator und einem HIL-Simulator, bei dem der HIL-Simulator der Simulationsmaster ist,
- Fig. 2: schematisch eine Loose Coupling-Kommunikation mit Pufferung,
- Fig. 3: schematisch einen Vergleich zwischen den Zeitbasen im SIL-Simulator und im HIL-Simulator,
- Fig. 4: schematisch eine Situation, bei der unabhängig vom Vorhandensein von Puffern auf Empfängerseite das Bus-Timing beim Austausch von Daten zwischen SIL-Simulator und HIL-Simulator immer noch inkonsistent ist,
- Fig. 5: eine vereinfachte Darstellung der Situation aus Fig. 4,
- Fig. 6: schematisch ein Verfahren gemäß einem bevorzugten Ausführungsbeispiel der Erfindung,
- Fig. 7: schematisch weitere Schritte des Verfahrens aus Fig. 6 und
- Fig. 8: schematisch ein Verfahren gemäß einem weiteren bevorzugten Ausführungsbeispiel der Erfindung.

Wie eingangs beschrieben, betrifft die vorliegende Erfindung den Fall der Co-Simulation mit einem SIL-Simulator und einem HIL-Simulator. Ein herkömmlicher Ansatz für die Co-Simulation und das damit verbundene Verständnis von Co-Simulation besteht darin, dass eine Komponente oder ein Teilsystem das Timing des gesamten Simulationssystems übernimmt, so dass diese Komponente bzw. dieses Teilsystem als Simulationsmaster bezeichnet werden kann.

Die vorliegende Erfindung befasst sich mit dieser Art von Co-Simulationen, die mitunter auch mit Strong Coupling bezeichnet werden, aber gerade nicht: Vielmehr geht es vorliegend um ein Simulationssystem, das zwei Subsysteme aufweist, nämlich einen SIL-Simulator und einen HIL-Simulator, die jeweils eigenständige Simulatoren sind, und anstatt einen externen Simulations-Master einzubeziehen oder einen der beiden Simulatoren als Timing-Controller zu nutzen, wird beiden Simulatoren erlaubt, ihr Timing-Verhalten beizubehalten und Daten auszutauschen, wann immer sie verfügbar sind. Dieser Co-Simulationsansatz wird auch mit Loose Coupling bezeichnet.

Dieser Loose Coupling-Ansatz hat den Vorteil, dass er die Simulationsleistung erhöht, indem er die Leerlaufzeiten beider Simulatorkomponenten reduziert und das Risiko einer Zeitüberschreitung (Task Overrun) im HIL-Simulator verringert. Dies hat jedoch den Nachteil, dass das Gesamtsystem nicht automatisch deterministisch ist und zeitliche Inkonsistenzen in der Kommunikation entstehen können. Wegen dieser Nachteile ist der Loose Coupling-Ansatz für die in Rede stehende Art von Co-Simulation häufig nicht berücksichtigt worden, und stattdessen ist Strong Coupling-Ansätzen der Vorzug gegeben worden. Strong Coupling kann jedoch für viele Simulationssysteme ungeeignet sein, insbesondere für sehr rechenintensive Aufgaben.

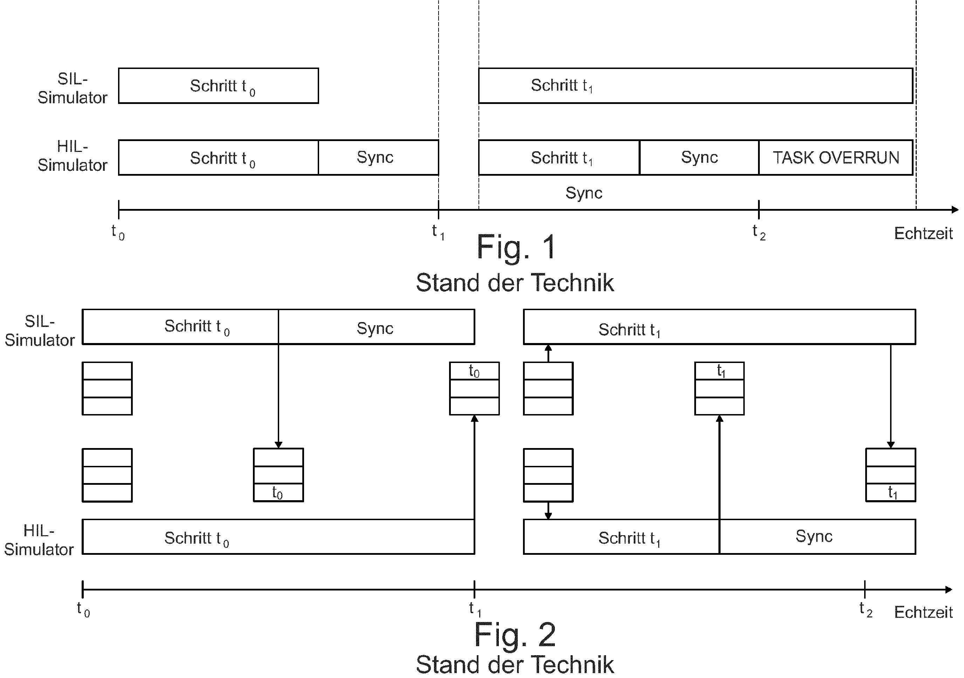

Aus Fig. 1 ist ein Beispiel für einen Strong Coupling-Ansatz zwischen einem SIL-Simulator und einem HIL-Simulator ersichtlich, bei dem der HIL-Simulator der Simulationsmaster ist. In diesem Beispiel braucht der SIL-Simulator im Schritt *t₁* länger als eine Taktdauer, um diesen Schritt auszuführen, der in Echtzeit weniger als eine Taktdauer beansprucht, was zu einem Task Overrun im HIL-Simulator führt, wodurch dieser die Echtzeitsynchronisation verliert. Ein solches Phänomen tritt unabhängig davon auf, welche Komponente der Simulations-Master ist, wenn der SIL-Simulator nicht in der Lage ist, die Echtzeitfähigkeiten zu erhalten, selbst wenn dies nur vorübergehend geschieht. Dieser kurzzeitige Verlust der Echtzeitfähigkeit ist bei SIL-Systemen praktisch unvermeidbar, wenn z. B. rechenintensive Schritte auftreten oder Schritte durch Betriebssystem- bzw. Systemaufrufe unterbrochen werden.

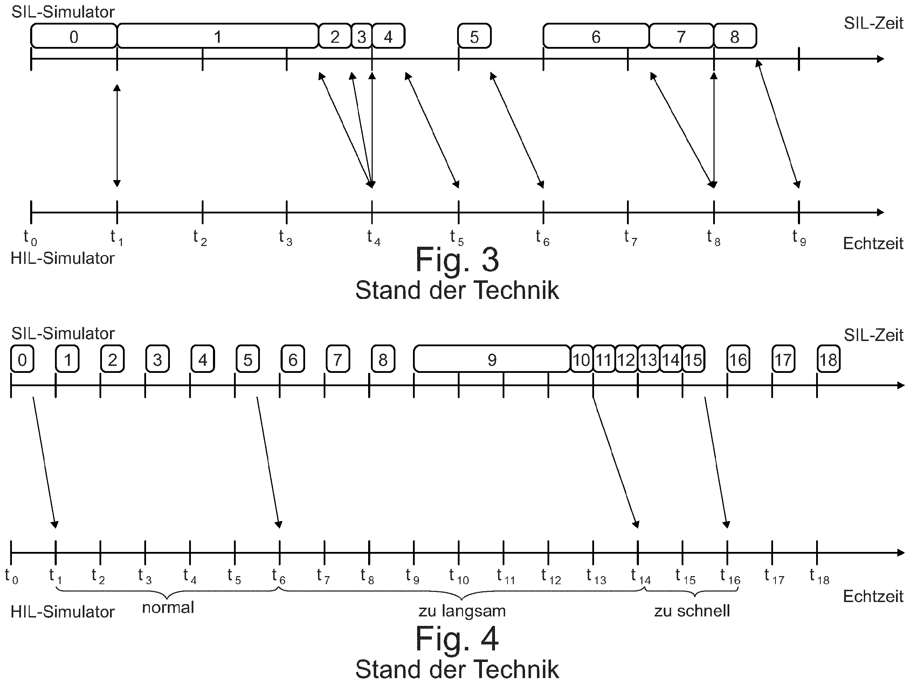

Vorliegend geht es nun um einen Loose Coupling-Ansatz, wobei darauf abgezielt wird, die Nachteile von Loose Coupling durch die Verringerung bzw. Vermeidung des Auftretens von zeitlichen Inkonsistenzen zu verringern. Eine Loose Coupling-Kommunikation beinhaltet in der Regel eine Pufferung, wie in Fig. 2 dargestellt. In diesem Fall führt ein Simulationsschritt, der länger dauert als in Echtzeit, im SIL-Simulator nur zu einer kleinen Verzögerung bei der Nachrichtenkommunikation und nicht zu einem Verlust der Echtzeitfähigkeit des HIL-Simulators. Dies ist der übliche Stand der Technik, wenn es um Loose Coupling-Ansätze geht. Im Falle des Austauschs von Bussimulationsdaten ist es außerdem üblich, immer genau dann Busnachrichten auszutauschen, wenn diese verfügbar sind. Problematisch bei der Kopplung eines SIL-Simulators mit einem HIL-Simulator im Rahmen eines Loose-Coupling-Ansatzes kann es jedoch sein, dass der SIL-Simulator vorübergehend die Synchronisation mit dem Echtzeitsystem verliert, wenn ein Simulationsschritt länger dauert als die vorgegebene Taktdauer und weitere Schritte in schneller Folge ausgeführt werden, um diese Verzögerung auszugleichen. Ein solches Verhalten ist Fig. 3 dargestellt.

Fig. 3 zeigt einen Vergleich zwischen den Zeitbasen im SIL-Simulator und im HIL-Simulator. Der SIL-Simulator ist so konfiguriert, dass er auf seine gesamte Laufzeit gesehen die Echtzeit einhält. Das bedeutet, dass der Simulator im Falle eines länger als eine Echtzeittaktdauer dauernden Simulationsschritts versucht, das damit verbundene Nacheilen aufzuholen, um wieder eine Synchronisation zwischen realer und simulierter Zeit zu erzielen. Bei Loose Coupling-Ansätzen und für den Fall, dass ausschließlich Busnachrichten ausgetauscht werden, kann dieses Verhalten zu unerwünschten Folgen im Bus-Timing-Verhalten führen, selbst im Falle einer hier vorgestellten gepufferten Kommunikation. Dies ist schematisch in Fig. 4 dargestellt.

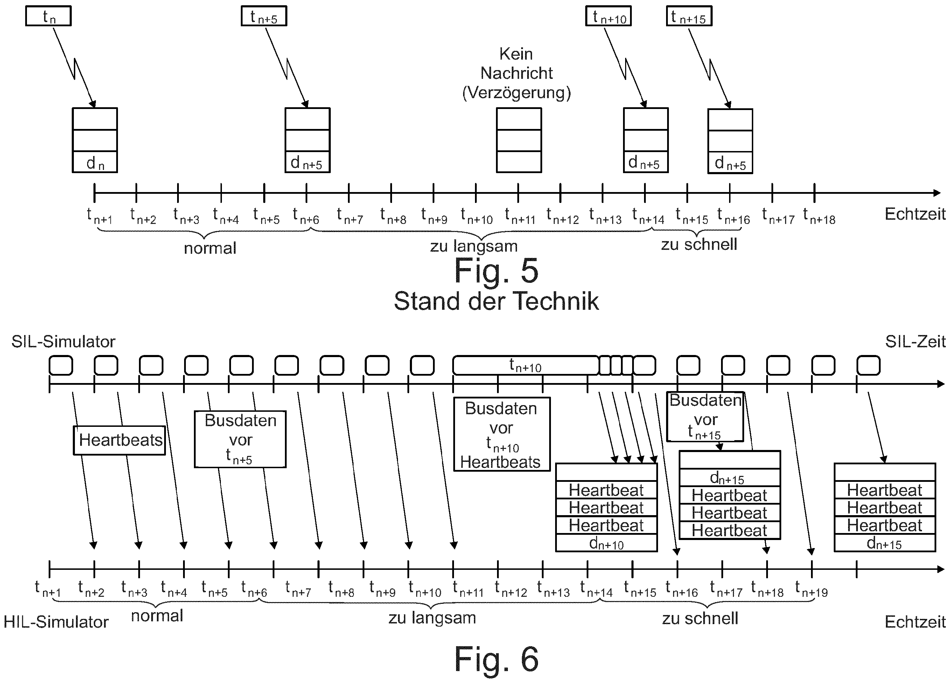

Aus Fig. 4 ist ersichtlich, dass unabhängig vom Vorhandensein von Puffern auf Empfängerseite das Bus-Timing beim Austausch von Daten zwischen Echtzeit- und Nicht-Echtzeit-System immer noch inkonsistent ist. Im Folgenden werden teilweise vereinfachte Darstellungen verwendet, indem nur die Empfangsseite des HIL-Systems gezeigt wird. Das in Fig. 4 dargestellte Verhalten stellt sich dann dar, wie in Fig. 5 gezeigt. In Fig. 5 ist die HIL-Seite des Datenaustauschs im Rahmen der Simulation gezeigt: Aufgrund eines momentanen Verlusts der Echtzeitfähigkeit auf der SIL-Seite treffen Busdaten, die alle 5 Simulationsschritte gelesen werden sollten, stattdessen in nahezu zufälligen Abständen ein. Da diese Daten sofort interpretiert und auf den Bus übertragen werden, führt dies zu Intervallen mit zufälliger Dauer zwischen den Busnachrichten. Diese zufälligen Intervalldauern können zu Buskollisionen und Fehlern bei angeschlossenen Steuergeräten auf der HII,-Seite führen. Größere Verzögerungen auf dem SIL-Simulator können damit zu erheblichen Warteschlangen und ggf. zu Datenverlusten führen. Hier setzt die Erfindung an, und zwar wie folgt:
Es sind weiterhin zwei Kommunikationskomponenten vorgesehen, nämlich ein in Echtzeit laufenden HIL-Simulator und ein in einer Simulationszeit laufenden SIL-Simulator, und zwar unter einem Loose Coupling-Ansatz. Diese Simulatoren tauschen sowohl Simulations-Metadaten als auch Busdaten über Ethernet aus, und zwar gemäß dem folgenden Verfahren:
Es wird ein periodischer Takt mit in einer konstanten Taktdauer aufeinanderfolgenden Taktzeitpunkten vorgegeben. Zum Taktzeitpunkt Null wird ein erster SIL-Simulationsschritt gestartet. Wenn der SIL-Simulationsschritt beendet ist, wird eine Nachricht erzeugt und von dem SIL-Simulator an den HIL-Simulator gesendet. Der Empfang der Nachricht erfolgt in einer FIFO-Warteschlange des HIL-Simulators. Zu jeweils einem Taktzeitpunkt wird aus der Warteschlange von dem HIL-Simulator jeweils eine Nachricht ausgelesen und anschließend in der Warteschlange gelöscht. Dieser Ablauf wird wiederholt, bis das Ende der Co-Simulation, erreicht ist.

Wesentlich ist dabei, dass nach dem Start des ersten SIL-Simulationsschritt zu einem Taktzeitpunkt Null hinsichtlich der darauf folgenden SIL-Simulationsschritte in einem Fall, in dem die Dauer des unmittelbar vorherige SIL-Simulationsschritts maximal die Taktdauer betragen hat, der unmittelbar darauf folgende SIL-Simulationsschritt zum jeweils nächst möglichen Taktzeitpunkt gestartet wird, und ansonsten der unmittelbar darauf folgende SIL-Simulationsschritt sofort nach Abschluss des vorherige SIL-Simulationsschritts gestartet wird, wie in Fig. 3 z. B. im Hinblick auf die Schritte 2 und 3 dargestellt. Beim Erzeugen der Nachrichten werden jedes Mal Simulations-Metadaten in die Nachricht aufgenommen, die den aktuellen Zustand der Warteschlange, die simulierte Zeit und die reale Zeit beinhalten, die lokal in dem SIL-Simulator bzw. in dem HIL-Simulator vorliegt. Diese Nachrichten werden als Heartbeat-Nachrichten bezeichnet. Außerdem werden in genau in jede fünfte Nachricht Busdaten aufgenommen wird, die Eigenschaften eines Busses des SIL-Simulators charakterisieren. Diese Nachrichten werden auch als Bus-Nachrichten bezeichnet. Diese Ausgestaltung ermöglicht es, Probleme beim Bus-Timing zu vermeiden, wenn Nachrichten in zu geringem Abstand ankommen, wie in Fig. 6 schematisch dargestellt.

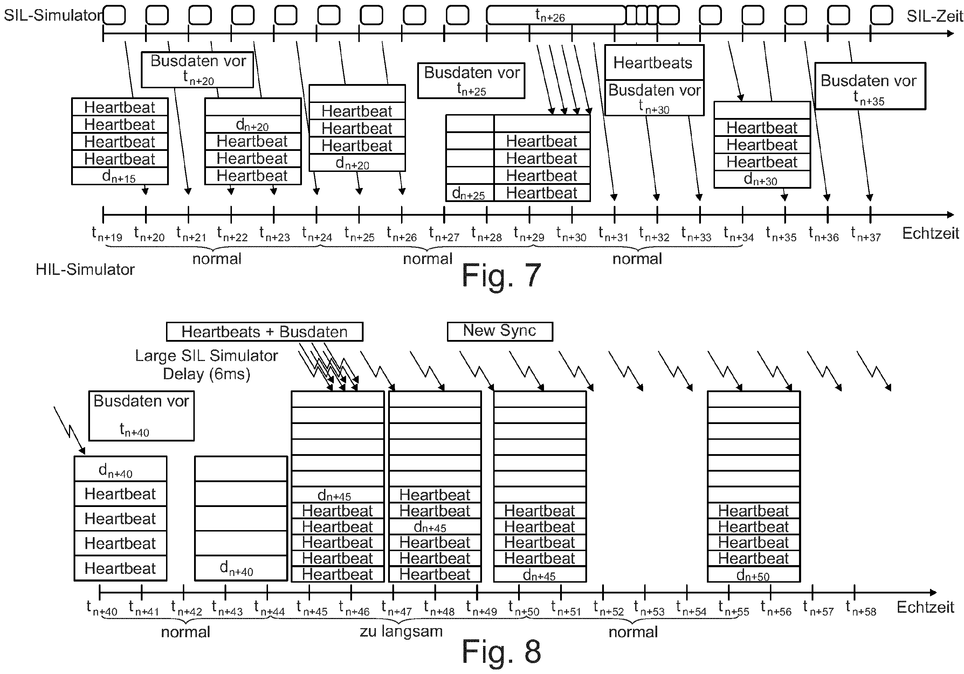

Da in jedem Simulationsschritt genau eine Nachricht ausgegeben wird, unabhängig davon, ob diese Busdaten beinhaltet oder nicht, werden Situationen vermieden, in denen Bus-Nachrichten mit Busdaten aufgrund eines vorherigen Verlusts der Echtzeitfähigkeit des SIL-Simulators in zu geringem Abstand vom HIL-Simulator aus der Warteschlange ausgelesen werden. Außerdem ermöglicht es dieser Ansatz, einen gewissen Puffer an Heartbeat-Nachrichten und Bus-Nachrichten zu behalten, wenn eine solche Abweichung vom Echtzeitverhalten auftritt. Dies hat den Effekt, dass das System vor weiteren Synchronisationsverlusten derselben Größenordnung geschützt wird, mit dem Nebeneffekt, dass sich die Zeitverzögerung zwischen den beiden Simulatoren erhöht, der SIL-Simulator also nicht noch weiter dem HIL-Simulator hinterhereilt. Ein Beispiel dafür ist schematisch in Fig. 7 dargestellt. Fig. 7 veranschaulicht die Fortführung des Beispiels aus Fig. 6 von der Zeit *t*_{*n*+*19*} an. In diesem Fall schützt der Rückstau von drei Nachrichten, der auf ein verzögertes Senden von drei Nachrichten zurückgeht, das System vor weiteren Verzögerungen um drei Nachrichten.

Außerdem wird gemäß einem bevorzugten Ausführungsbeispiel der Erfindung ein Verfahren zur Neusynchronisierung bereitgestellt, wie schematisch in Fig. 8 dargestellt. Dieser Mechanismus ermöglicht es, eine Heartbeat-Nachricht zu ignorieren, und zwar, indem die FIFO-Warteschlange um zwei Schritte verschoben und damit eine Heartbeat-Nachricht eliminiert wird, wenn die Synchronisation zwischen den Komponenten erheblich beeinträchtigt ist. In dem in Fig. 8 dargestellten Fall hat eine besonders große Verzögerung von Simulationsschritten eine anschließende Warteschlange mit sechs Nachrichten auf der HIL-Seite zur Folge gehabt. Um eine entsprechend große Verzögerung zwischen den Simulatoren zur vermeiden, ist eine Hearbeat-Nachricht aus der Warteschlange verworfen worden. Auf diese Weise kann das System im Falle eines besonders langen SIL-Berechnungsschritts innerhalb eines bestimmten Zeitrahmens wieder zu einem akzeptablen Warteschlangenstatus zurückkehren.

## Patentansprüche

1. Computerimplementiertes Verfahren zur Co-Simulation mit einem in Echtzeit laufenden HIL-Simulator und einem in einer Simulationszeit laufenden SIL-Simulator, mit folgenden Verfahrensschritten:
Vorgeben eines periodischen Taktes mit in einer konstanten Taktdauer aufeinanderfolgenden Taktzeitpunkten,
a) Starten eines SIL-Simulationsschrittes,
b) Erzeugen einer Nachricht und Senden der Nachricht von dem SIL-Simulator an den HIL-Simulator, wenn der SIL-Simulationsschritt beendet ist,
c) Empfangen der Nachricht in einer Warteschlange des HII,-Simulators,
d) Auslesen jeweils einer Nachricht zu einem Taktzeitpunkt aus der Warteschlange von dem HIL-Simulator und Löschen dieser Nachricht in der Warteschlange derart, dass eine zuerst von der Warteschlange empfangene Nachricht vor einer später empfangen Nachrichten ausgelesen und dann in der Warteschlange gelöscht wird,
e) Wiederholen der Schritte a) bis d) bis zu einem Ende der Co-Simulation, wobei
der erste SIL-Simulationsschritt zu einem ersten Taktzeitpunkt gestartet wird und hinsichtlich der darauf folgenden SIL-Simulationsschritte in einem Fall, in dem die Dauer des unmittelbar vorherige SIL-Simulationsschritts maximal die Taktdauer betragen hat, der unmittelbar darauf folgende SIL-Simulationsschritt zum jeweils nächst möglichen Taktzeitpunkt gestartet wird, und ansonsten der unmittelbar darauf folgende SIL-Simulationsschritt sofort nach Abschluss des vorherige SIL-Simulationsschritts gestartet wird.

2. Computerimplementiertes Verfahren nach Anspruch 1, wobei beim Erzeugen einer Nachricht jedes Mal ein wenigstens eine Eigenschaft der Co-Simulation charakterisierendes Simulations-Metadatum in die Nachricht aufgenommen wird.

3. Computerimplementiertes Verfahren nach Anspruch 2, wobei das Simulations-Metadatum ausgewählt ist aus folgenden Daten:
der aktuelle Zustand der Warteschlange,
die simulierte Zeit und
die reale Zeit, die lokal in dem SIL-Simulator bzw. in dem HIL-Simulator vorliegt.

4. Computerimplementiertes Verfahren nach einem der vorhergehenden Ansprüche, wobei genau in jede n-te Nachricht ein wenigstens eine Eigenschaft eines Busses des SIL-Simulators charakterisierendes Busdatum aufgenommen wird, wobei n konstant, ganzzahlig und größer als 1 ist.

5. Computerimplementiertes Verfahren nach Anspruch 4, wobei für einen Fall, in dem die Warteschlange mehr als eine vorbestimmte Anzahl an Nachrichten enthält, Schritt d) dahingehend ergänzt wird, dass nach dem Auslesen und Löschen der Nachricht die nachfolgende Nachricht in der Warteschlange ohne Auslesen gelöscht wird, sofern es sich hierbei nicht um eine Nachricht handelt, in die ein Busdatum aufgenommen worden ist.

6. Computerimplementiertes Verfahren nach Anspruch 5, wobei in einem Fall, in dem die Nachricht nicht ohne Auslesen gelöscht worden ist, da es sich um eine Nachricht gehandelt hat, in die ein Busdatum aufgenommen worden ist, im nachfolgenden Schritt d) nach dem Auslesen und Löschen der Nachricht, in die ein Busdatum aufgenommen worden ist, die nachfolgende Nachricht in der Warteschlange ohne Auslesen gelöscht wird.

7. Computerimplementiertes Verfahren nach einem der vorhergehenden Ansprüche, wobei der Versand der Nachricht von dem SIL-Simulator an den HIL-Simulator über Ethernet erfolgt.
